# FASCICULE DE BREVET EUROPEEN

(11) **EP 0 231 703 B1**
(45) Date de publication et mention de la délivrance du brevet: **25.08.1993**
(21) Numéro de dépôt: 86402894.9
(22) Date de dépôt: 22.12.1986
(51) Int. Cl.: H01L 21/31, H01L 29/86

(54) **Procédé de fabrication d'une résistance électrique par dopage d'un matériau semiconducteur.**
Verfahren zur Herstellung eines elektrischen Widerstands mittels Dotierung eines Halbleitermaterials.
Process for manufacturing an electrical resistance by means of doping a semiconductive material.

(30) Priorité: 27.12.1985 FR 8519344
(43) Date de publication de la demande: 12.08.1987
(73) Titulaire: BULL S.A., 92800 Puteaux (FR)
(72) Inventeur: Boudou, Alain, F-75016 Paris (FR); Marchetaux, Jean-Claude, F-75016 Paris (FR); Doyle, Brian, F-75016 Paris (FR)
(74) Mandataire: Denis, Hervé

(56) Documents cités:
- EP-A- 0 107 556
- EP-A- 0 159 408
- FR-A- 2 117 977
- US-A- 3 925 106
- IBM TECHNICAL DISCLOSURE BULLETIN, vol. 24, no. 7a, décembre 1981, pages 3460-3461, New York, US; S.A. ABBAS et al.: "Electrically alterable resistors"
- SOLID-STATE ELECTRONICS, vol. 19, no. 12, décembre 1976, pages 1021-1027, Pergamon Press, GB; K.R. WHIGHT et al.: "Implanted high value resistors"
- ELECTRONICS, vol. 53, no. 1, janvier 1980, pages 39-40, New York, US; R. ALLAN: "Thin-film devices on silicon chip withstand up to 500 C"

## Description

L'invention se rapporte à un procédé de fabrication d'une résistance électrique par dopage d'un matériau semiconducteur. L'invention s'applique aussi bien au matériau monocristallin qui constitue le substrat du circuit intégré qu'au matériau semiconducteur polycristallin couramment inclus dans le réseau d'interconnexion des composants d'un circuit intégré.

La formation d'une résistance électrique par dopage d'une zone d'un matériau semiconducteur monocristallin, ordinairement le silicium, diffère selon que le matériau est initialement dopé ou non dopé.

Le matériau monocristallin non dopé constitue le substrat à partir duquel sont formés les circuits intégrés. Une résistance dans une zone du substrat est faite par dopage d'ions électriquement actifs, capables de définir dans le matériau un type de conductivité N ou P. Pour le silicium, les ions actifs sont par exemple l'arsenic, le phosphore ou le bore. La valeur de la résistance dépend de la concentration (densité) des ions actifs dans la zone selon une courbe complexe qui rend déjà difficile l'ajustement désiré de la valeur de la résistance.

En outre, il s'avère que le substrat subit toujours au moins un recuit subséquemment à la formation de la résistance. L'expérience montre qu'un recuit fait diffuser les ions actifs de manière pratiquement anisotrope de la zone vers ses parties environnantes. La densité des ions et, par conséquent, la valeur de la résistance subissent ainsi une modification dont l'ampleur dépend notamment de la température du recuit, de la densité initiale des ions et du gradient de densité à la périphérie de la zone résistive. Etant donné que les parties périphériques de la zone résistive ne sont pas dopées, le gradient est toujours élevé. De plus, compte tenu des nombreux paramètres impliqués, de leurs effets propres très variables et de leur influence mutuelle complexe, la valeur de la résistance ne peut pas être ajustée à la valeur souhaitée dans des marges significatives. De surcroît, la diffusion agrandit notablement la surface de la zone initialement dopée et s'oppose ainsi à l'intégration élevée des composants du substrat. Il en résulte qu'en pratique ce procédé de formation de résistance n'offre aucune maîtrise de la valeur de la résistance et qu'il n'est mis en oeuvre que dans les cas où la seule contrainte est une valeur limite de la résistance.

Les résistances que l'on trouve dans le substrat monocristallin d'un circuit intégré sont ordinairement des zones résistives contenues dans des régions déjà dopées. Compte tenu de la résistivité relativement faible d'une région initialement dopée, le procédé de fabrication d'une zone résistive dans cette région diffère selon que la valeur de sa résistance est plus faible ou plus forte que celle de la région dopée.

Pour obtenir une résistance plus faible, on dope fortement la zone résistive. Cependant, une telle résistance doit s'étendre entre deux contacts pour son insertion dans un circuit électrique. Dans ce cas, la résistance de la région vient se mettre en parallèle avec la résistance intrinsèque de la zone résistive. La résistance effective de la zone diffère donc de sa résistance intrinsèque en fonction du rapport entre la résistance intrinsèque de la zone et la résistance de la région avoisinante du substrat. Pour diminuer l'influence de la résistance du substrat, on attribue à la zone résistive une faible résistance par rapport à celle du substrat. Cependant, les fortes concentrations de dopants que nécessite une telle zone se cumulent avec l'existence de forts gradients de densité à la périphérie de la zone pour contribuer à une diffusion extensive des ions de la zone initialement dopée vers la région environnante. Cette diffusion empêche toute maîtrise du procédé, alors que cette maîtrise s'avère nécessaire pour ajuster correctement de faibles valeurs de résistance. Un palliatif consiste à changer le type de conductivité des ions entre la zone et la région de façon à les isoler par une jonction P-N comme cela est décrit dans le document FR-A-2 117 977. Toutefois, la jonction impose des valeurs de tensions relatives, tandis que le changement de nature des ions n'évite pas leur diffusion.

La fabrication d'une zone de résistance plus élevée dans une région initialement dopée est illustrée dans le brevet US N^{o} 4 432 008. La zone résistive est placée en surface de la région pour être directement en contact avec un conducteur du réseau d'interconnexion du circuit intégré. De cette manière, la zone résistive se trouve placée en série avec le conducteur et la région conductrice. Ceci nécessite donc dans le monocristal une région fortement dopée, telle que la région de drain d'un transistor à effet de champ dans l'exemple choisi. Mais l'avantage est de n'avoir plus qu'un seul contact avec le conducteur et de pouvoir ainsi réduire la surface de la zone résistive autour de ce seul contact.

Pour accroître la résistance de la zone dans la région de drain d'un transistor, il est préconisé d'introduire dans la zone des dopants inactifs qui, pour le silicium, sont l'or, l'argent, le zinc et le cuivre. Cependant, il s'avère qu'en pratique, tous ces ions inactifs diffusent de la même manière que les ions actifs lors d'un recuit. De plus, pour accroître notablement la résistivité de la zone par rapport a celle de la région, il est nécessaire d'y introduire une grande quantité d'ions inactifs. La périphérie de la zone résistive sera donc le siège d'un dort gradient de densité. A titre d'exemple, pour une zone de silicium dopée avec des ions d'or dont le coefficient de diffusion D est 10⁻¹⁰cm²/sec. et ayant subi un recuit ordinaire effectué à la température d'environ 1000°C pendant une demi-heure, l'expérience révèle que les ions d'or ont diffusé sur une distance moyenne d'environ 4 micromètres (4 um). On retrouve donc les mêmes inconvénients que ceux exposés précédemment au sujet du procédé de formation d'une zone résistive dans le substrat non dopé. D'une part, une telle diffusion empêche tout ajustement efficace et fiable de la résistance de la zone résistive. D'autre part, la diffusion augmente considérablement les dimensions de la zone résistive initiale et s'oppose ainsi à la haute intégration des composants dans le substrat. En outre, des ions inactifs issus de la zone résistive et diffusés dans la région avoisinante peuvent contaminer des secteurs fonctionnellement actifs du substrat, tels que le secteur situé sous la couche d'oxyde de grille du transistor à effet de champ qui inclut la zone résistive dans son drain comme dans le cas illustré dans le brevet US cité. Dans ce cas, la contamination est réputée très néfaste sur les caractéristiques du transistor.

Compte tenu sans doute des difficultés rencontrées lors de la formation d'une résistance par introduction des ions inactifs précités, le brevet US suggère d'accroître la résistance en créant des défauts du réseau cristallin dans la zone résistive. Malheureusement, l'expérience montre que le recuit ne laisse subsister qu'une très faible proportion des défauts initiaux. Au demeurant, il est remarquable que ce brevet ne mentionne pas à titre d'illustration les valeurs de résistance auxquelles le procédé décrit peut donner lieu.

A cause de toutes les difficultés rencontrées pour la formation de zones résistives dans le substrat monocristallin d'un circuit intégré, on les insère couramment dans le réseau multicouche d'interconnexion des composants du circuit intégré lorsque celui-ci contient une couche conductrice faite en un matériau semiconducteur polycristallin, ordinairement le silicium. Par exemple, on trouve habituellement un tel réseau dans les circuits intégrés incluant des transistors à effet de champ du type MOS (Métal-Oxide-Semiconducteur), dont les grilles sont faites en un matériau semiconducteur polycristallin. On profite de l'étape de fabrication de ces grilles pour former le premier niveau du réseau d'interconnexion des composants du circuit intégré. La fabrication de ce premier niveau d'interconnexion comprend le dépôt d'une couche d'épaisseur uniforme de matériau semiconducteur polycristallin, la gravure de cette couche pour y graver les éléments d'interconnexion, et l'implantation à forte dose d'ions actifs pour rendre conducteurs les éléments d'interconnexion.

La formation de zones résistives dans les éléments polycristallins d'interconnexion est faite habituellement selon un procédé classique tel que décrit par exemple dans l'article de Ohzone et al. paru dans la revue "The Transaction of the IECE of Japan", Vol. E 63, numéro 4, Avril 1980, pages 267-274. Selon ce procédé antérieur, une première implantation d'ions actifs à faible dose est faite dans tout le matériau semiconducteur polycristallin non dopé. La dose est calculée pour diminuer la résistivité du matériau non dopé jusqu'à atteindre la valeur désirée pour la formation des résistances dans le matériau. Ces résistances sont ensuite délimitées dans des zones par masquage du matériau initialement dopé. On procède ensuite à une seconde implantation ionique à forte dose pour abaisser considérablement la résistance électrique du matériau non masqué constituant les parties conductrices de la couche. Le bombardemnent ionique ayant altéré la structure du matériau, celui-ci est ensuite recuit pour restaurer la structure initiale.

Cependant, le recuit provoque aussi dans un matériau polycristallin une diffusion des dopants de manière pratiquement anisotrope et similaire à celle des dopants dans le matériau monocristallin. Autrement dit, la diffusion dépend des mêmes paramètres tels que le gradient de densité des dopants, la nature des dopants et la température du recuit. En outre, elle dépend de la granulométrie du matériau polycristallin, qui favorise la diffusion et la rend plus importante que celle relative au matériau monocristallin. Les zones résistives sont donc envahies par les ions présents à forte dose dans les parties conductrices voisines, au point qu'une zone de petite surface devient conductrice et perd son rôle de résistance et qu'une zone de grande surface ne conserve qu'une région centrale ayant la résistivité désirée. La diffusion s'oppose ainsi à l'intégration à haute densité des résistances dans le matériau polycristallin. Actuellement, les zones résistives souhaitées sont des carrés de l'ordre de 2 um de côté, absolument impossibles à obtenir avec le procédé antérieur. D'autre part, compte tenu des nombreux paramètres liés à la diffusion, de leur effet propre selon des fonctions compliquées et de leur influence mutuelle complexe, le procédé ne peut être maîtrisé pour ajuster dans une marge significative la valeur souhaitée d'une zone résistive. A titre d'exemple, l'expérience montre que la résistance du silicium polycristallin varie d'un facteur de 10⁴ à 10⁶ pour une dose d'ions variant simplement d'un facteur 10.

La grande dispersion des valeurs de résistance obtenues par ce procédé fait que celui-ci n'est actuellement applicable que pour la fabrication de résistances très élevées, de l'ordre du Gigohm ou plus. Dans ces gammes de résistances, des variations de l'ordre de Mégohm sont peu conséquentes. De surcroît, de telles valeurs correspondent à une partie de pente faible de la courbe de résistivité en fonction du dopage des ions. Les circuits intégrés concernés par ce procédé antérieur de formation de résistance sont notamment les mémoires statiques RAM (Random Access Memory) du type MOS.

Le brevet US précité N^{o} 4 432 008 présente la formation d'une résistance dans une zone d'un matériau semiconducteur polycristallin consistant à doper uniformément le matériau d'ions actifs et à implanter dans la zone des ions inactifs identiques à ceux exposés ci-dessus dans le cadre du substrat monocristallin. Cependant, pour les mêmes raisons que précédemment, l'expérience prouve que les dopants proposés diffusent encore plus dans le matériau polycristallin à cause de sa structure granuleuse. Ces dopants ne peuvent ainsi procurer une maîtrise suffisante pour un ajustement significatif de la résistance souhaitée des zones résistives. D'autre part, la combinaison proposée des ions inactifs avec la formation de défauts dans le matériau polycristallin s'avère expérimentalement sans effet substantiel, du fait que le recuit redonne approximativement au matériau polycristallin sa granulométrie initiale. Les valeurs de résistivité des zones résistives sont donc très voisines de la résistivité du matériau.

Une solution efficace a été fournie par la demanderesse dans sa demande de brevet européen n^{o} 107 556. En bref, une résistance est formée dans une zone du matériau polycristallin par dopage à forte dose d'ions actifs et par implantation d'ions de la famille des gaz rares en quantité et avec une énergie suffisantes pour atteindre la résistivité souhaitée. Ce procédé permet d'obtenir de manière fiable et précise des résistances de très faible surface dans une gamme de l'ordre de 250 Ohms à 25 kilohms environ.

Cette invention fut aussi conçue dans l'esprit d'annuler le gradient de la densité des ions électriquement actifs qui existait auparavant entre les zones et les parties conductrices voisines. L'annulation est faite par un dopage uniforme à forte dose des ions actifs dans l'ensemble du matériau polycristallin. Dans cet esprit, on estimait que l'action des gaz rares dans une zone résistive était celle des ions inactifs mentionnée dans le brevet US précité et que leur meilleure efficacité, par rapport aux autres ions inactifs, était due à une meilleure synergie avec les ions actifs introduits à forte dose dans les zones résistives en vue d'annuler le gradient de densité ionique. Cette annulation limite le procédé à la formation de faibles valeurs de résistance à cause de la forte dose d'ions actifs. Par exemple, les expériences faites avec l'argon dans les conditions décrites dans la demande de brevet européen révèlent que le procédé se limite à la fabrication de résistances ajustées avec précision dans une marge de l'ordre de 250 ohms à 25 kilohms. Autrement dit, alors que le procédé classique n'est applicable qu'aux très fortes résistances, le procédé perfectionné ne s'applique qu'aux très faibles résistances et ne peut couvrir la gamme des résistances intermédiaires. Pourtant, la possibilité de fabriquer des résistances intermédiaires de manière précise et de faible encombrement permettrait la réalisation de nouveaux types de circuits intégrés répondant aux souhaits des utilisateurs.

En résumé, la technique actuelle pose le problème général de la fabrication d'une résistance dans une zone d'un matériau semiconducteur monocristallin ou polycristallin, dopé ou non. Seule la formation de faibles résistances dans un matériau semiconducteur polycristallin fortement dopé a été maîtrisée. La cause de ce problème est essentiellement la diffusion des ions de dopage résistif lors d'un recuit. Les inconvénients qui en découlent sont principalement le manque de maîtrise des procédés pour ajuster une résistance à la valeur souhaitée dans une faible marge de tolérance et la nécessité de travailler avec des résistances de grandes dimensions, incompatibles avec la très haute intégration souhaitée. A cela s'ajoute dans certains cas la contamination des ions de dopage résistif dans des secteurs fonctionnellement sensibles du substrat et l'altération des caractéristiques des composants contaminés.

L'invention résout ce problème général par le fait qu'elle réduit notablement ou annule la diffusion des ions de dopage résistif lors d'un recuit. Elle évite par conséquent tous les inconvénients des procédés antérieurs.

L'invention a pour objet un procédé de fabrication d'une résistance dans une zone d'une région non dopée de matériau semiconducteur monocristallin, comprenant les étapes successives du procédé défini par la revendication 1.

L'invention a aussi pour objet un procédé de fabrication d'une résistance dans une zone d'une région de matériau semiconducteur monocristallin uniformément dopé d'ions actifs, comprenant les étapes successives du procédé défini par la revendication 2.

L'invention a encore pour objet un procédé de fabrication d'une résistance dans une zone d'une région initialement non dopée d'un matériau semiconducteur polycristallin, comprenant les étapes successives du procédé défini par la revendication 3.

L'invention va maintenant être décrite en référence aux exemples illustrés dans les dessins annexés.

Dans les dessins :
- la figure 1 est une vue en coupe partielle du substrat semiconducteur monocristallin d'un circuit intégré incluant une résistance conforme à l'invention ;
- la figure 2 est une vue similaire à celle de la figure 1, illustrant une variante de réalisation d'une résistance conforme à l'invention dans le substrat semiconducteur monocristallin d'un circuit intégré ; et
- les figures 3 et 4 illustrent le procédé conforme à l'invention de formation d'une résistance dans un matériau semiconducteur polycristallin.

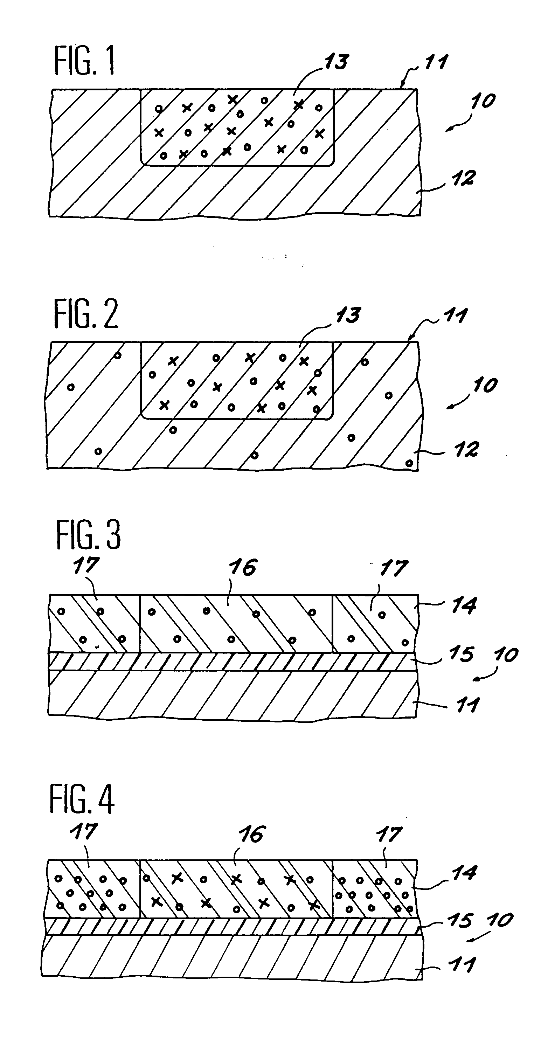

Dans le circuit intégré (10) représenté partiellement sur la figure 1, le substrat (11) en matériau semiconducteur monocristallin incorpore à la surface d'une région non dopée (12) une zone (13) constituant une résistance conforme à l'invention. La zone résistive (13) contient des ions actifs, d'arsenic par exemple, représentés par des points et des ions inactifs représentés par des croix. La périphérie de la zone (13) est donc le siège d'un gradient de densité d'ions actifs. Selon l'invention, les ions inactifs sont des ions de gaz rares. L'argon est avantageux du fait de ses performances et de son faible coût. Sachant que la présence d'ions actifs diminue la résistance du matériau semiconducteur et que la présence d'ions inactifs en accroît la résistance, les ions actifs sont introduits à une dose plus forte que celle nécessaire pour donner à eux seuls la valeur de résistance désirée. La valeur de la résistance est ajustée par l'implantation d'ions de gaz rares en fonction notamment de la densité de ces ions et de leur énergie d'implantation. D'une manière générale, l'implantation de gaz rares est temporellement indépendante de l'introduction des ions actifs. Autrement dit, elle peut être antérieure, simultanée ou postérieure à l'introduction d'ions actifs pourvu que le recuit leur soit postérieur. Le dopage des ions actifs peut aussi être fait par diffusion ou par implantation ionique.

L'expérience a en effet révélé des propriétés spécifiques des gaz rares par rapport aux autres ions inactifs tels que ceux proposés dans le brevet US précité. En bref, il s'avère que les ions implantés de gaz rares ont la particularité d'empêcher, aux hautes températures de recuit, à la fois la restauration de la structure du matériau semiconducteur et la diffusion aussi bien des ions actifs que les ions de gaz rares. L'absence de diffusion des ions actifs et des ions de gaz rares a l'avantage de permettre l'ajustement de la valeur de la résistance indépendamment de tout gradient de densité ionique à la périphérie de la zone résistive. Elle a aussi l'avantage de maintenir la zone résistive dans ses dimensions initiales, qui peuvent alors être très réduites (2um de côté par exemple) et s'adapter ainsi aux très hautes densités d'intégration. Elle élimine par ailleurs toute contamination de secteurs environnants par des ions issus de la zone résistive. D'autre part, le fait que les ions des gaz rares empêchent la restauration de la structure du matériau semiconducteur que l'implantation ionique a disloquée offre l'avantage de pouvoir modifier sensiblement et de façon contrôlée la valeur de la résistance du matériau. Ce fait d'expérience explique maintenant les avantages constatés dans la demande de brevet européen précitée.

Dans le circuit intégré (10) représenté partiellement sur la figure 2, la région (12) et la zone résistive (13) du substrat monocristallin (11) sont initialement dopées uniformément en ions actifs. Selon l'invention, la zone (13) contient des ions actifs supplémentaires qui font que la périphérie de la zone est le siège d'un gradient de densité d'ions actifs, et des ions inactifs de gaz rares tels que l'argon. Les ions dans la zone (13) en accroissent la résistivité en fonction de leur densité et de leur énergie d'implantation et permettent l'ajustement de la valeur de la résistance. De même, l'implantation des ions de gaz rares est temporellement indépendante de l'introduction des ions actifs si le recuit leur est postérieur.

En référence aux figures 3 et 4, le substrat monocristallin (11) du circuit intégré (10) supporte une couche (14) en matériau semiconducteur polycristallin par l'intermédiaire d'une couche d'isolation (15). La couche (14) comprend une zone (16) constituant une résistance conforme à l'invention, et une partie restante conductrice (17). Le procédé conforme à l'invention pour la formation d'une résistance dans la zone (16) rend possible l'application du procédé classiquement utilisé pour former une résistance dans un matériau polycristallin malgré la présence d'un fort gradient de densité d'ions actifs à la périphérie de la zone (16). Dans la couche (14) initialement non dopée, on implante uniformément des ions actifs à faible dose comme représenté sur la figure 3A. Puis, après masquage de la zone (16) on implante les ions actifs à forte dose dans la partie restante (17) de la couche pour la rendre conductrice, comme indiqué à la figure 3B. Selon l'invention, on implante aussi dans la zone (16) des ions de gaz rares tels que l'argon. L'implantation initiale à faible dose d'ions actifs est donc faite en tenant compte notamment de la densité des ions de gaz rares et de leur énergie d'implantation de manière à ajuster la résistance à la valeur désirée. L'implantation ionique de gaz rares est temporellement indépendante du dopage uniforme initial d'ions actifs, ou encore après le dopage à forte dose dans la partie restante (17), si le recuit leur est postérieur. Le matériau semiconducteur polycristallin peut être le silicium ou un composé de matériau semiconducteur avec un matériau réfractaire tel que le siliciure de tungstène WSi2.

## Revendications

1. Procédé de fabrication d'une résistance dans une zone (13) d'une région (12) non dopée de matériau semiconducteur monocristallin, le procédé consistant à doper la zone (13) dans la région (12) non dopée en introduisant des ions actifs à une dose plus forte que celle nécessaire pour donner à eux seuls la valeur de résistance désirée et à implanter des ions de gaz rare dans cette zone pour en ajuster la valeur, l'implantation des ions de gaz rare étant temporellement indépendante de l'introduction des ions actifs, pourvu que le recuit du matériau leur soit postérieur.

2. Procédé de fabrication d'une résistance dans une zone (13) d'une région (12) de matériau semiconducteur monocristallin uniformément dopé d'ions actifs, le procédé consistant à doper la zone (13) dons actifs supplémentaires à une valeur de résistance inférieure à la valeur desirée et à implanter des ions de gaz rare dans cette zone pour en ajuster la valeur, l'implantation des ions de gaz rare étant temporellement indépendante de l'introduction des ions actifs, pourvu que le recuit du matériau leur soit postérieur.

3. Procédé de fabrication d'une résistance dans une zone (16) d'une région (14) initialement non dopée d'un matériau semiconducteur polycristallin, le procédé consistant à doper uniformément d'ions actifs à faible dose tout le matériau à une valeur de résistance inférieure à la valeur désirée, à doper, après masquage de la zone (16), des ions actifs à forte dose dans la région pour la rendre conductrice et à implanter des ions de gaz rare dans la zone pour en ajuster la valeur, l'implantation des ions de gaz rare étant temporellement indépendante du dopage uniforme initial d'ions actifs ainsi que du dopage à forte dose dans la région, pourvu que le recuit du matériau leur soit postérieur.

4. Procédé selon l'une des revendications 1 à 3, caractérisé en ce que la résistance est ajustée à la valeur désirée par l'implantation d'ions de gaz rare en fonction de leur densité et de leur énergie d'implantation.

5. Procédé selon l'une des revendications 1 à 4, caractérisé en ce que le dopage est effectué par diffusion des ions actifs.

6. Procédé selon l'une des revendications 1 à 4, caractérisé en ce que le dopage en ions actifs consiste en une implantation.

## Claims

1. Method of producing a resistance in a zone (13) of a non-doped region (12) of monocrystalline semiconductive material, the method consisting of doping the zone (13) in the non-doped region (12) by introducing active ions in a dose stronger than that required to give them the desired resistance value and implanting rare gas ions in this zone to adjust its value, the implantation of rare gas ions being temporally independent of the introduction of active ions, provided that the annealing of the material occurs late.

2. Method of producing a resistance in a zone (13) of a region (12) of monocrystalline semiconductive material uniformly doped with active ions, the method consisting of doping the zone (13) with supplementary active ions to a resistance value lower than the desired value and implanting rare gas ions in this zone to adjust the value, the implantation of rare gas ions being temporally independent of the introduction of active ions, provided that the annealing of the material occurs later.

3. Method of producing a resistance in a zone (16) of an initially non-doped region (14) of a polycrystalline semiconductive material, the method consisting of uniformly doping all the material with a weak dose of active ions to a resistance value lower than the desired value, doping in the region, after masking the zone, with a strong dose of active ions to make it conductive and implanting rare gas ions in the zone to adjust the value, the implantation of rare gas ions being temporally independent of the uniform initial doping with active ions as well as the doping with a strong dose in the region, provided that the annealing of the material occurs later.

4. Method according to one of claims 1 to 3, characterised in that the resistance is adjusted to the desired value by the implantation of rare gas ions as a function of their density and their energy of implantation.

5. Method according to one of claims 1 to 4, characterised in that the doping is effected by diffusion of active ions.

6. Method according to one of claims 1 to 4, characterised in that the doping with active ions consists of an implantation.

## Patentansprüche

1. Verfahren zum Herstellen eines Widerstandes in einer Zone (13) eines nicht dotierten Gebiets (12) aus monochristallinem Halbleitermaterial, wobei das Verfahren darin besteht, daß die Zone (13) in dem nicht dotierten Gebiet (12) dotiert wird, indem aktive Ionen mit einer Dosis eingeführt werden, die stärker als die ist, die notwendig ist um durch sie allein den gewünschten Widerstandswert zu ergeben, und daß Edelgasionen in diese Zone zum Einstellen des Werts implantiert werden, wobei das Implantieren der Edelgasionen zeitlich unabhängig von der Einführung der aktiven Ionen geschieht, vorausgesetzt, daß die Wärmebehandlung des Materials nachher geschieht.

2. Verfahren zum Herstellen eines Widerstandes in einer Zone (13) eines gleichmäßig mit aktiven Ionen dotierten Gebiets (12) aus monokristallinem Halbleitermaterial, wobei das Verfahren darin besteht, daß die Zone (13) mit zusätzlichen aktiven Ionen mit einem Widerstandswert dotiert wird, der kleiner als der gewünschte Wert ist, und daß in diese Zone zum Einstellen des Wertes Edelgasionen implantiert werden, wobei das Implantieren der Edelgasionen zeitlich unabhängig von der Einführung der aktiven Ionen ist, vorausgesetzt, daR die Wärmebehandlung des Materials nachher geschieht.

3. Verfahren zum Herstellen eines Widerstandes in einer Zone (16) eines anfänglich nicht dotierten Gebiets (14) eines polykristallinen Halbleitermaterials, wobei das Verfahren darin besteht, daß das gesamte Material gleichmäßig mit aktiven Ionen mit einem Widerstandswert dotiert wird, der kleiner als der gewünschte Wert ist, daß nach einer Maskierung der Zone (16) Aktivionen mit hoher Dosis in das Gebiet dotiert werden, damit dieses leitend wird, und daß in die Zone zur Einstellung des Wertes Edelgasionen implantiert werden, wobei das Implantieren der Edelgasionen zeitlich unabhängig von der anfänglichen gleichmäßigen Dotierung mit aktiven Ionen sowie von der Dotierung mit hoher Dosis in dem Gebiet erfolgt, vorausgesetzt, daß die Warmebehandlung des Materials nachher geschieht.

4. Verfahren nach einem der Ansprüche 1 bis 3, dadurch gekennzeichnet, daß der gewünschte Widerstand durch Implantieren von Edelgasionen in Abhängigkeit von ihrer Dichte und ihrer Implantierungsenergie eingestellt wird.

5. Verfahren nach einem der Ansprüche 1 bis 4, dadurch gekennzeichnet, daß das Dotieren durch Diffusion aktiver Ionen erfolgt.

6. Verfahren nach einem der Ansprüche 1 bis 4, dadurch gekennzeichnet, daß das Dotieren mit aktiven Ionen aus einer Implantation besteht.
